# EUROPÄISCHE PATENTSCHRIFT

(11) **EP 2 110 678 B1**
(45) Veröffentlichungstag und Bekanntmachung des Hinweises auf die Patenterteilung: **07.05.2014**
(21) Anmeldenummer: 08154462.9
(22) Anmeldetag: 14.04.2008
(51) Int. Cl.: G01R 31/34, H02K 11/00

(54) **Vorrichtung zur Inspektion eines Spaltes**
Device for the inspection of a gap
Dispositif d'inspection d'un entrefer

(43) Veröffentlichungstag der Anmeldung: 21.10.2009
(73) Patentinhaber: Alstom Technology Ltd, 5400 Baden (CH)
(72) Erfinder: Moser, Roland, 8005 Zürich (CH); Hugi, Niklaus, 5400 Baden (CH); Mark, Bernhard, 79761 Waldshut (DE); Isler, Philipp, 5603 Staufen (CH); Honold, Simon, 4052 Basel (CH); Erni, Josef, 8400 Winterthur (CH)
(74) Vertreter: Dimper, Dieter

(56) Entgegenhaltungen:
- EP-A- 1 863 153
- DE-U1- 8 219 963

## Beschreibung

### Technisches Gebiet

Die Erfindung betrifft eine Vorrichtung zur Inspektion eines schmalen Luftspaltes zwischen zwei Oberflächen mittels einer Sonde, wobei mindestens eine der zwei Oberflächen ferromagnetisch ist. Sie betrifft insbesondere eine Vorrichtung mit einem Motor zur Bewegung der Sonde, wobei der Motor ausserhalb des Spaltes angeordnet ist und die Sonde durch einen einzigen Zugang in den Spalt einführbar ist.

### Stand der Technik

Maschinen, Motoren und industrielle Apparate mit langer Betriebsdauer werden typischerweise in regelmässigen Zeitabständen auf ihre Funktionstüchtigkeit inspiziert. Zum Beispiel werden Turbinen, Boiler oder Generatoren auf Schäden an den Oberflächen der Bauteile inspiziert, um ein Versagen oder Schäden während des Betriebs zu vermeiden, indem gegebenenfalls Schäden behoben oder Bauteile ersetzt werden müssen. Um eine Inspektion mit möglichst wenig Aufwand und in kurzer Zeit zu vollbringen, soll die Maschine nach Möglichkeit nicht auseinander gebaut werden. Häufig stehen dann jedoch zur Inspektion nur ein begrenzter Raum und schmale Zugänge zur Verfügung. Zum Beispiel werden Stator und Rotor eines Generators über einen schmalen Luftspalt zwischen den Oberflächen des Stators und Rotors inspiziert.

Für Inspektionen dieses Art sind verschiedene Inspektionsvorrichtungen wie folgt bekannt.

Zum Beispiel ist in US 6,672,413 eine ferngesteuerte Vorrichtung zur Inspektion von Räumen offenbart, die durch Menschen nicht zugänglich sind. Sie umfasst einen oder mehrere Wagen, die durch ein Scharnier miteinander verbunden sind. Die Wagen verfügen über einen Motor sowie Magneten, die den Kontakt mit den Oberflächen gewährleisten, insbesondere mit Oberflächen, von denen die Vorrichtung aufgrund der Schwerkraft sonst abgleiten würde. Die Vorrichtung eignet sich aufgrund ihrer Grösse und Komplexität nur für Räume ab einer bestimmten Grösse.

EP 684483 offenbart ein System zur Inspektion eines Generators, dessen Rotor für eine Inspektion nicht ausgebaut werden muss. Es umfasst einen oder mehrere Sensoren auf einem Wagen mit Rädern, die gleichzeitig entlang den Oberflächen des Rotors sowie in Nuten des Stators rollen. Die Vorrichtung wird mittels einem Motor ausserhalb der zu inspizierenden Maschine und einem Kabel bewegt, das sich über die Länge der Maschine bis zu deren beiden Enden erstreckt. Während das System eine Inspektion eines schmalen Spaltes ab einer Grösse von 40 mm ermöglicht, ist zu deren Installation ein Zugang von beiden Seiten der Maschine notwendig.

EP 1420260 offenbart einen Detektor zur Inspektion eines Generatorstators mit eingebautem Rotor mit einer Schiene, die am einen Ende des Stators montiert und in Statornuten magnetisch befestigt ist. Der Wagen lässt sich nach Einbau der Schiene entlang der Schiene mittels einem ferngesteuerten Antrieb, einem aufziehbaren Kabel, vorzugsweise mit einer Umlenkrolle, sowie einer Feder bewegen.

In EP1233278 ist eine Vorrichtung zur Inspektion des Luftspalts zwischen Stator und Rotor eines Generators bei eingebautem Rotor, für dessen Befestigung ein Zugang von beiden Seiten des Luftspalts erforderlich ist.

US 6,100,711 offenbart eine Vorrichtung zur Inspektion eines Luftspalts in einem Generator. Die Vorrichtung umfasst einen verlängerbaren Masten, der zwecks Positionierung im Luftspalt mittels Seitenelementen mit dessen Seitenwänden in Kontakt gebracht wird. Ein Motor zur Fortbewegung der Vorrichtung ist auf dieser selbst montiert. Die Vorrichtung erfordert eine Mindesthöhe des Luftspaltes von einem halben Zoll.

EP 1 863 153 offenbart eine Inspektionsvorrichtung für einen Luftspalt, die einen Masten in der Form eines expandierbaren und zusammenklappbaren Rohrs umfasst, auf dem ein Sensorkopf befestigt ist. Hierzu besteht der Masten aus zwei Teilen, die ihrer Länge nach sich voneinander trennen und damit den Masten aufweiten. Der Masten besteht aus einem aufrollbaren Material, das mittels einem Antrieb ausserhalb des Luftspaltes aus- und aufgerollt wird. Der Masten wird in einem zusammengeklappten Zustand von einem Ende des Spalts in den Luftspalt eingeführt. Nachdem er eingeführt ist, wird er in seiner Breite aufgeweitet, sodass er die erforderliche Steifigkeit erreicht, um den Sensor fortzubewegen. Der Sensor und Masten werden sodann mittels des Antriebs entlang der Länge des Spaltes geführt. Bei Nicht-Verwendung des Sensors wird der Masten in seinem zusammengeklappten Zustand aufgerollt aufbewahrt.

### Darstellung der Erfindung

Der vorliegenden Erfindung ist die Aufgabe gestellt, eine Vorrichtung zur automatischen Inspektion von schmalen Luftspalten zwischen Oberflächen zu schaffen, wobei mindestens eine Oberfläche ferromagnetisch ist, wie zum Beispiel in Maschinen, insbesondere Generatoren. Die Vorrichtung soll eine Inspektion von schmalen Luftspalten erlauben, ohne dass die Luftspalten durch einen Ausbau von Bauteilen vergrössert werden müssen. Zudem soll die Vorrichtung einfach und effizient installiert und innerhalb des Luftspaltes bewegt werden können.

Die Aufgabe wird durch die Merkmale des unabhängigen Anspruchs 1 gelöst. Vorteilhafte Weiterbildungen ergeben sich aus den abhängigen Ansprüchen.

Eine Vorrichtung zur Inspektion eines Luftspaltes zwischen Oberflächen, wovon mindestens eine der zwei Oberflächen ferromagnetisch ist, weist eine Sensorplattform für einen oder mehrere Sensoren auf, die an einem länglich ausgebildeten, ausfahrbaren Träger befestigt ist, wobei der Träger durch eine einzige Zugangsöffnung in den Spalt ein- und herausführbar, mittels einem Antrieb über die Länge des Spaltes vorwärts und zurück führbar und ausserhalb des Spaltes aufrollbar ist. Erfindungsgemäss weist der Träger, zumindest im ausgefahrenen Zustand, in einem zu seiner Längserstreckung senkrechten Querschnitt eine Krümmung auf. Zusätzlich weist der Träger eine Mehrzahl von Magneten auf, die über die Länge des Trägers verteilt sind und den Träger in Kontakt mit einer ferromagnetischen Oberfläche bringen und halten. Die Magneten sind dabei an einer Oberfläche des Trägers befestigt, die von der ferromagnetischen Oberfläche abgewandt ist.

Die Krümmung im Querschnitt gewährt dem Träger in seinem ausgefahrenen Zustand eine Steifigkeit, die es ermöglicht, den Träger in einen Spalt einzuführen, ohne dass dieser durchhängt oder sich biegt. Die Magnete am Träger gewährleisten zudem, dass der Träger während der Bewegung entlang dem Spalt sowie der Inspektionsmessungen im Spalt in Kontakt mit der ferromagnetischen Oberfläche bleibt. Dies ermöglicht einerseits, zusammen mit der Krümmung des Trägers, dass der Träger in den Spalt bis zu dessen Ende kontrolliert eingeführt und wieder herausgeführt werden kann, ohne dass dieser sich biegt, wölbt oder von der ferromagnetischen Oberfläche wegbewegt. Der Kontakt mit der Oberfläche gewährleistet zudem, dass in jeder Position entlang des Spaltes die gleiche Distanz zwischen dem Sensormesskopf und der ferromagnetischen Oberfläche aufrechterhalten bleibt.

Die Magnete sind an einer Oberfläche des Trägers befestigt, die von der ferromagnetischen Oberfläche, mit welcher der Träger in Kontakt ist, abgewandt ist. Sie sind somit nicht in direktem Kontakt mit der ferromagnetischen Oberfläche, sondern wirken von der abgewandten Seite her durch den Träger hindurch. Die Befestigung der Magnete an der ferromagnetischen Oberfläche abgewandten Seite des Trägers ermöglicht ein einwandfreies Gleiten entlang der Oberfläche, ohne dass die Magnete sich an Unregelmässigkeiten der Oberfläche anstossen könnten. Zudem vermeidet diese Platzierung, dass der Träger durch die Magnetkräfte zu stark an der Oberfläche festgehalten und ein Gleiten behindert würde.
Die Magnete garantieren zudem, dass der Träger mit dem Sensor auch dann mit ferromagnetischen Oberflächen in Kontakt bleibt, wenn die Schwerkraft am Träger entgegen der Haltekraft der Magneten wirkt.

Der Träger ist aufrollbar, was eine Lagerung in kleinem Raum und damit auch eine vielseitige Platzierung der Vorrichtung an Stellen in Maschinen mit begrenzten Raumverhältnissen ermöglicht. Zudem vereinfacht die raumeffiziente Lagerung den Transport und die Handhabung der Vorrichtung.

In einer Ausführung der Erfindung weist die Sensorplattform mehrere weitere Magnete sowie ein oder mehrere gleitfähige oder rollende Elemente auf. Diese Magneten sind wiederum in oder an der Sensorplattform angeordnet, dass sie nicht in direktem Kontakt mit der ferromagnetischen Oberfläche sind. Die Bauhöhe der ein oder mehreren gleitfähigen oder rollenden Elemente sind grösser als die der Magneten, sodass sie von der Oberfläche der Sensorplattform gegenüber den Magneten hervorstehen. Somit können sie direkt auf einer ferromagnetischen Oberfläche gleiten oder rollen. Dies gewährleistet, dass der Sensor stets und in allen Positionen in einem Spalt in Kontakt mit einer ferromagnetischen Oberfläche bleibt und zugleich ein Gleiten oder Rollen der Sensorplattform entlang der Oberfläche bei möglichst kleinem Widerstand ermöglicht ist.
In einer ersten Variante dieser Ausführung sind die Magnete in der Sensorplattform eingebettet, indem ihre Oberflächen in der gleichen Ebene sind wie die Oberfläche der Plattform oder ihre Oberflächen leicht unter der Oberfläche der Plattform und von einem gleitfähigen Material auf der Sensorplattform überdeckt sind. Dies gewährleistet ein einwandfreies Gleiten der Sensorplattform auf der Oberfläche.
In einer zweiten Variante dieser Ausführung sind die Magnete auf der Oberfläche der Sensorplattform angeordnet, wobei auf derselben Oberfläche zusätzlich eine Mehrzahl von Rollelementen angeordnet sind. Die Rollelemente sind dabei so dimensioniert und angeordnet, dass sie von der Plattformoberfläche gegenüber den Magneten vorstehen und die Magnete entsprechend zurückversetzt sind und somit nicht in direkten Kontakt mit der ferromagnetischen Oberfläche kommen.

In einer weiteren Ausführung weist die Vorrichtung eine Träger- oder Lagerungsrolle auf, mit welcher der Träger aufgerollt und wieder abgerollt und ausgefahren werden kann. Sie ermöglicht eine Lagerung des Trägers auf kleinstmöglichem Raum und somit eine Positionierung der Vorrichtung an Orten mit begrenzten Platzverhältnissen und einen einfachen Transport zur Inspektion einer weiteren Maschine.

In einer weiteren Ausführung der Erfindung weist die Vorrichtung ein Paar oder mehrere Paare von Führungselementen auf, zwischen denen der Träger beim Ausfahren hindurchgeführt wird und welche dazu dienen, die Richtung des ausfahrenden Trägers festzulegen. In einer ersten Variante besteht ein Paar von Führungselementen aus einem unbeweglichen Element und einem um seine eigene Achse rotierbaren Element. Das unbewegliche Element weist Flächen auf, welche die konvexe Seite einer Krümmung oder Tangenten zu Teilen der konvexen Seite einer Krümmung bilden. Das rotierbare Element besteht aus einer Walze mit Flächen, welche die konkave Seite einer Krümmung oder Teile der konkaven Seite einer Krümmung bilden. Das unbewegliche Element und das rotierbare Element sind so angeordnet, dass die konkav angeordneten Flächen des rotierenden Elementes in die konvexen Flächen oder Flächenteile des unbeweglichen Elementes hineinragen.
In einer zweiten Variante besteht ein Paar von Führungselementen aus einem Paar von Führungswalzen, wobei jedes Paar von Führungswalzen aus einer Walze mit einem konvexen Querschnitt und einer Walze mit einem konkaven Querschnitt gleicher Krümmung besteht. Die konvexe Walze ist bezüglich der konkaven Walze angeordnet, sodass das konvex gekrümmte Teil in das konkav gekrümmte Teil der anderen Führungswalze hineinragt.

In beiden Varianten ist der Träger zwischen den beiden Führungswalzen hindurchführbar, wobei dessen Krümmung den Krümmungen der Walzen entspricht.

In einer weiteren Ausführung weist der Träger entlang jeder Längsseite eine Mehrzahl von regelmässig voneinander beabstandeten Öffnungen auf. Eine Transportwalze, die vom Antrieb gedreht wird, weist eine Mehrzahl von Nocken auf, die gemäss den Öffnungen dimensioniert, positioniert und beabstandet sind. Der Träger wird über diese Transportwalze geführt, indem beim Ausfahren und Einrollen des Trägers die Nocken an der Transportwalze in die Öffnungen am Träger eingreifen. Dies bewirkt, dass beim Ausfahren und Einrollen der Träger entsprechend der Antriebskraft bewegt wird, ohne zu rutschen. Die Nocken und Öffnungen ermöglichen zudem eine Bestimmung der Länge des ausgefahrenen Trägers und die Position des Trägers innerhalb des Spaltes aufgrund eines Impulssignals des Antriebs. Die Transportwalze kann gleichzeitig auch als Führungselement mit entsprechend und vorgängig beschriebenen geformten Flächen dienen.

In einer weiteren Ausführung der Erfindung weist die Vorrichtung Kabel zur Übermittlung von Messsignalen vom Sensor an eine SignalverarbeitungsVorrichtung auf, wobei die Kabel entlang dem Träger geführt sind und an diesem befestigt und zusammen mit dem Träger aufrollbar sind.

In einer weiteren Ausführung weist die Vorrichtung auf der Sensorplattform eine Elektronik zur Digitalisierung der Messsignale und Übermittlung der Signale gemäss einem Übertragungsprotokoll auf. Dies gewährleistet eine genaue und zuverlässige Übermittlung der Signale.

In einer weiteren Ausführung weist die Vorrichtung einen Schleifring auf zur einwandfreien Übermittlung der Messsignale vom Ende des Trägers am Eingang zum Luftspalt über die Lagerungswalze zu einer Vorrichtung zur Verarbeitung und Darstellung der Messsignale.

In einer Ausführung der Erfindung besteht der Träger aus einem länglichen, streifenförmigen Element aus einem biegeelastischen Metall, beispielsweise Stahl, und einem zusätzlichen länglichen, streifenförmigen Element aus einem auf Metall gleitfähigen Kunststoff, wie zum Beispiel Polytetrafluorethylen (PTFE), auch unter Teflon^{™} bekannt, oder einem Polyethylen. Der Kunststoff, das Teflon^{™} oder Polyethylen ist auf der konvexen Seite des Trägers, das heisst auf der Seite des Trägers, die der ferromagnetischen Oberfläche zugewandt ist, in Form eines Streifens oder einer Beschichtung angeordnet. Diese Materialien erlauben ein Gleiten des Trägers entlang der ferromagnetischen Oberflächen sowie eine Wirkung der Magnetkraft durch das Trägermaterial. Das Teflon^{™} oder Polyethylen dient zudem als Isolation, die bei einer Messung des Magnetfelds notwendig ist, und schützt sowohl die ferromagnetische Oberfläche als auch den Träger gegen Abrieb. Das Material des Trägers zeichnet sich einerseits durch seine Flexibilität, die für das Aufrollen des Träges notwendig ist, und gleichzeitig durch seine Steifigkeit, die für Ausfahren und Führen im Spalt notwendig ist. Zudem verfügt es über einen Ermüdungswiderstand, der ein vielfaches Ausrollen und wieder Aufrollen ohne Einbusse seiner Steifigkeit erlaubt.

Um die Steifigkeit des Trägers weiter zu erhöhen, besteht in einer besonderen Ausführung der Träger aus mehreren, aufeinanderliegenden, biegeelastischen Metallstreifen, wobei der Streifen aus Kunststoff, Teflon^{™} oder Polyethylen auf der konvexen Oberfläche des äussersten Metallstreifens angeordnet ist.

In einer weiteren Ausführung weist die Vorrichtung einen zusätzlichen Antrieb für ihre Bewegung über den Umfang eines Rotors eines Generators auf. Die Sensorplattform kann einen oder mehrere Sensoren oder ein oder mehrere Messinstrumente aufweisen, wie zum Beispiel eine Kamera zur visuellen Inspektion oder Sensoren zur Niederinduktions-Eisenmessungen oder einer Messvorichtung zur Prüfung der Nutverkeilung in einem Generator.

In einer weiteren Ausführung der Erfindung weist die Sensorplattform ein oder mehrere Instrumente zum Greifen und Transportieren von Objekten im Spalt auf. Dies ermöglicht die gleichzeitige Entfernung von etwaigen Fremdkörpern oder unerwünschtem Material.

Aufgrund der Anordnung des Trägers und der Sensorplattform sowie der Art und Weise der kontrollierten Bewegung der Sensorplattform im Spalt, ermöglicht die erfindungsgemässe Vorrichtung Messungen in Spalten beispielsweise ab 4mm Höhe. Zudem ist die Vorrichtung durch ihre kleine und leichte Bauweise leicht transportierbar und handzuhaben und deshalb vielseitig einsetzbar.

### Kurze Beschreibung der Zeichnungen

Es zeigen
Figur 1 eine perspektivische Ansicht eines Generators einer Kraftanlage, in dem die erfindungsgemässe Vorrichtung angewendet werden kann,
Figur 2 eine nähere perspektivische Ansicht des Stators und Rotors des Generators von Figur 1 und dem zu inspizierenden Luftspalt,
Figur 3 eine Ansicht in einem Querschnitt entlang der Rotorachse eines mit III bezeichneten Teils des Stators und Rotors von Figur 2 mit einer Eintrittsgeometrie zum Luftspalt,
Figur 4 eine Gesamtansicht der erfindungsgemässen Inspektions-Vorrichtung, Figur 5 eine Teilansicht der erfindungsgemässen Inspektions-Vorrichtung, insbesondere eine nähere Ansicht der Vorrichtung zum Auf- und Abrollen eines Trägers für die Sensorplattform,
Figur 5a eine erste Variante von Elementen zur Führung des Trägers,
Figur 5b eine zweite Variante von Elementen zur Führung des Trägers,
Figur 6 eine Querschnittsansicht des Trägers gemäss VI-VI in Figur 4 senkrecht zur Längserstreckung des Trägers,
Figur 7a eine Teilansicht gemäss VIIa in Figur 4 einer ersten Variante einer Sensorplattform der Inspektionsvorrichtung,
Figur 7b eine Teilansicht gemäss VIIb in Figur 4 einer zweiten Variante einer Sensorplattform der Inspektionsvorrichtung,
Figur 8a eine Anordnung der Inspektionsvorrichtung im Luftspalt eines Generators in einem Querschnitt senkrecht zur Generatorachse,
Figur 8b eine nähere Ansicht der Inspektionsvorrichtung im Luftspalt eines Generators von Figur 8a.

### Ausführung der Erfindung

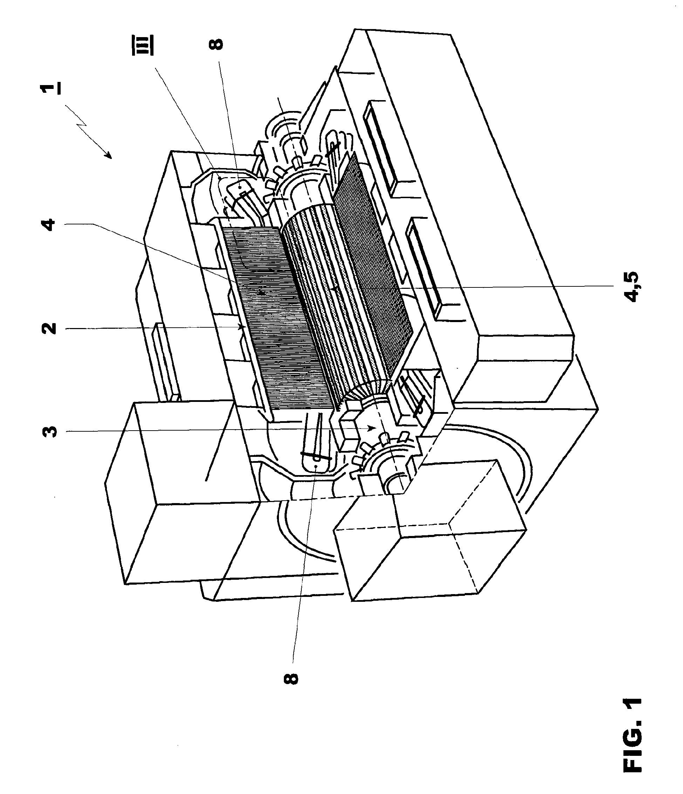

Figur 1 zeigt eine allgemeine Ansicht eines Generators 1 einer Kraftanlage, insbesondere dessen Stator 2 und Rotor 3 mit jeweils ferromagnetischen Elementen 4 (weiss) und nicht-ferromagnetischen Elementen 5 (grau schattiert).

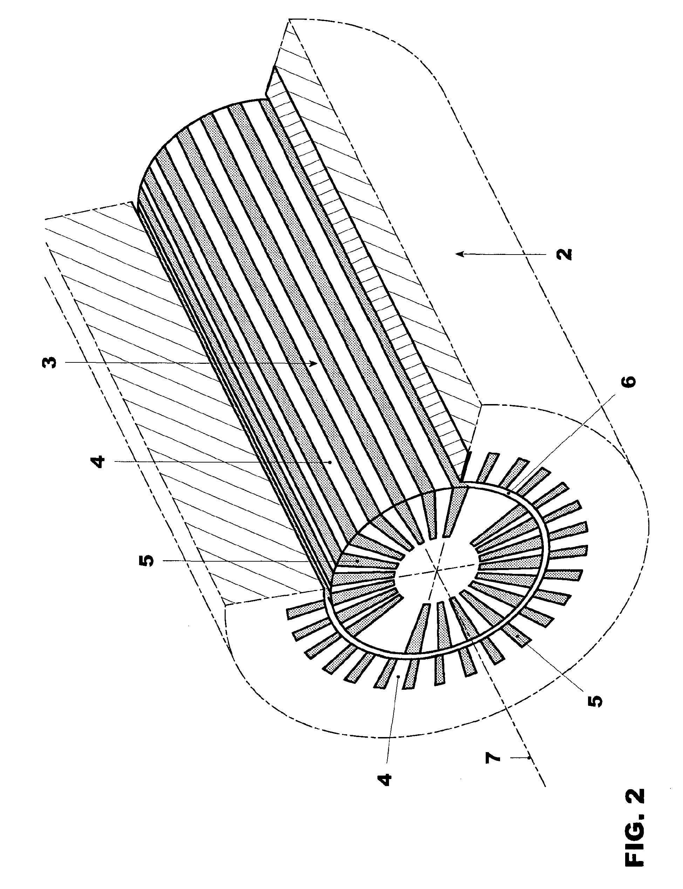

Figur 2 zeigt eine nähere Ansicht des Stators 2 und Rotors 3, zwischen denen sich ein schmaler, annularer Luftspalt 6 erstreckt. Die Oberflächen des Stators und Rotors weisen jeweils ferromagnetische Elemente 4 und nicht-ferromagnetische Elemente 5 auf, die über den Umfang alternierend angeordnet sind und sich parallel zur Generatorachse 7 erstrecken. Am Stator ist die Breite der einzelnen Elemente in der Regel konstant über dessen Umfang. Am Rotor ist die Breite ebenfalls konstant, mit Ausnahme des Bereichs der magnetischen Pole. Am Rotor ist das ferromagnetische Material das Rotormaterial selbst. Parallel zur Rotorachse erstrecken sich eine Mehrzahl von Nuten, in denen die Wicklung angeordnet ist und die mittels Keilen in den Nuten befestigt ist. Diese Keile sowie die Wicklung bilden die nicht-ferromagnetischen Elemente. Die Wicklung besteht aus Kupfer. Die Keile können aus verschiedenen, nicht-ferromagnetischen Materialien bestehen. Am Stator ist das ferromagnetische Material, ähnlich wie beim Rotor, das Statormaterial selbst, wobei das nicht-ferromagnetische Material das Material von Statorwicklung und Befestigungskeilen ist, die sich in Nuten parallel zueinander und parallel zur Achse des Generators erstrecken.

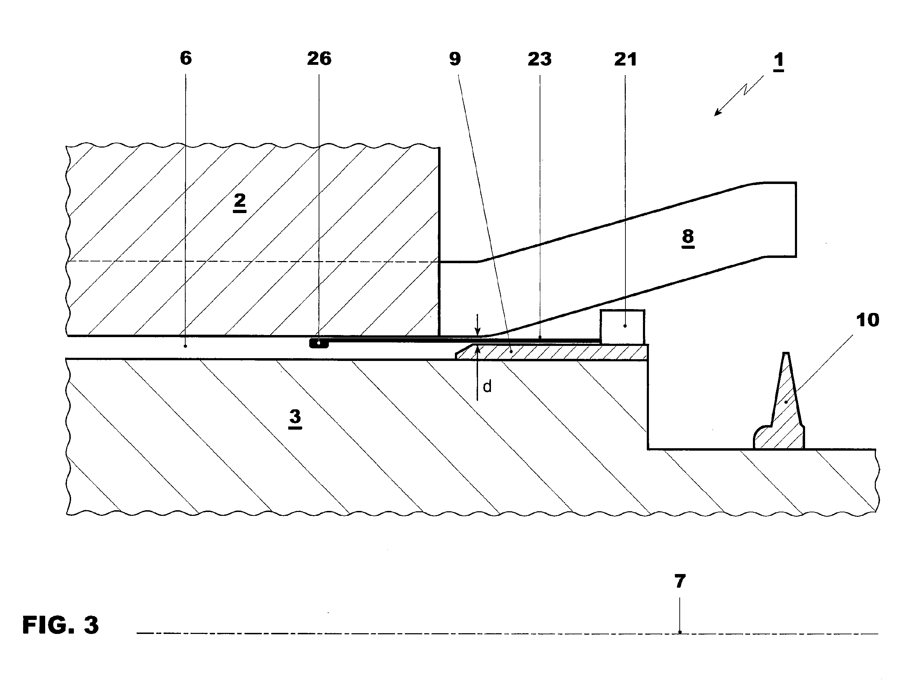

In Figur 3 ist eine typische Eintrittspartie zu einem Luftspalt 6 zwischen Stator 2 und Rotor 3 eines Generators 1 dargestellt. Die erfindungsgemässe Vorrichtung zur Inspektion ist in dieser Eintrittspartie platzierbar und der Träger mit Sensorplattform in den Spalt einführbar.
Am Rotor 3 befindet sich am Eingang zum Spalt auf dem Rotor 3 eine Rotorkappe 9, die sich parallel zur Generatorachse sowie radial zum Statorstab 8 hin erstreckt. Der Statorstab 8 und die Rotorkappe 9 definieren die Breite d des Spaltes 6, durch den der Träger 23 mit Sensorplattform 26 der Vorrichtung geführt werden soll. Diese kann beispielsweise nur 4 mm betragen. Der Träger 23 mit Sensorplattform 26 kann in der erfindungsgemässen Bauweise einen Spalt dieser Breite passieren.
Ausserhalb der Rotorkappe 9 ist ein Ventilator 10 angeordnet. Dieser begrenzt weiter die Platzverhältnisse für eine Inspektionsvorrichtung. Ein Gehäuse 21 kann dank der aufgerollten Lagerung des Sensorträgers dort platziert werden. Zudem ist die Vorrichtung aufgrund ihrer kompakten Grösse an verschiedene Eingangs-Geometrien von verschiedenen Generatoren anpassbar. Zwischen der Position des Gehäuses 21 und der Eingangsöffnung zum Spalt 6 kann in einer Variante der Erfindung zusätzlich eine Führungsschiene angeordnet sein, die den Träger bis zum Beginn der ferromagnetischen Oberflächen führen kann.

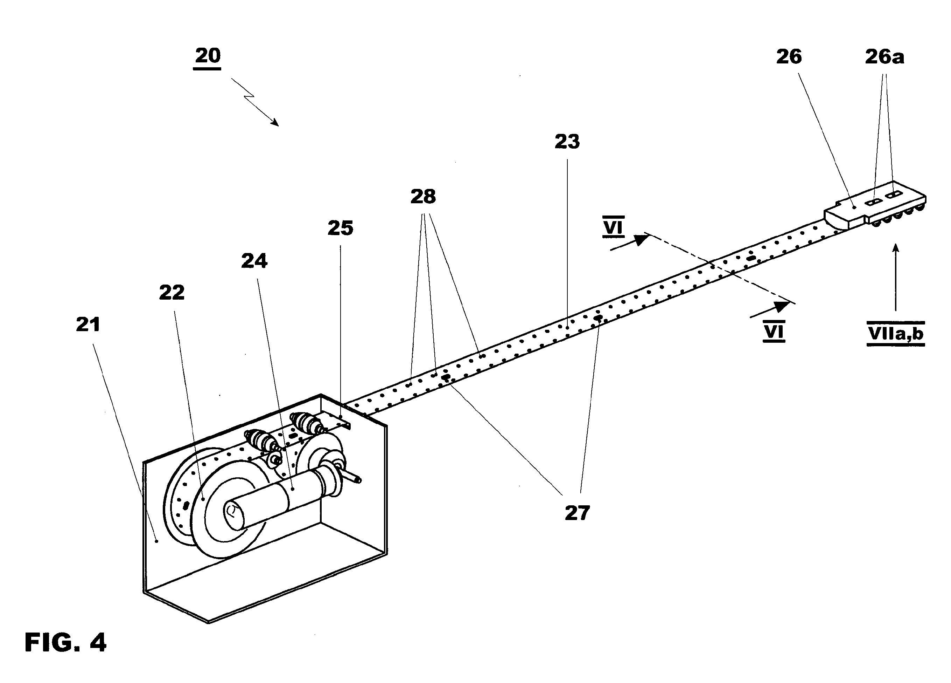

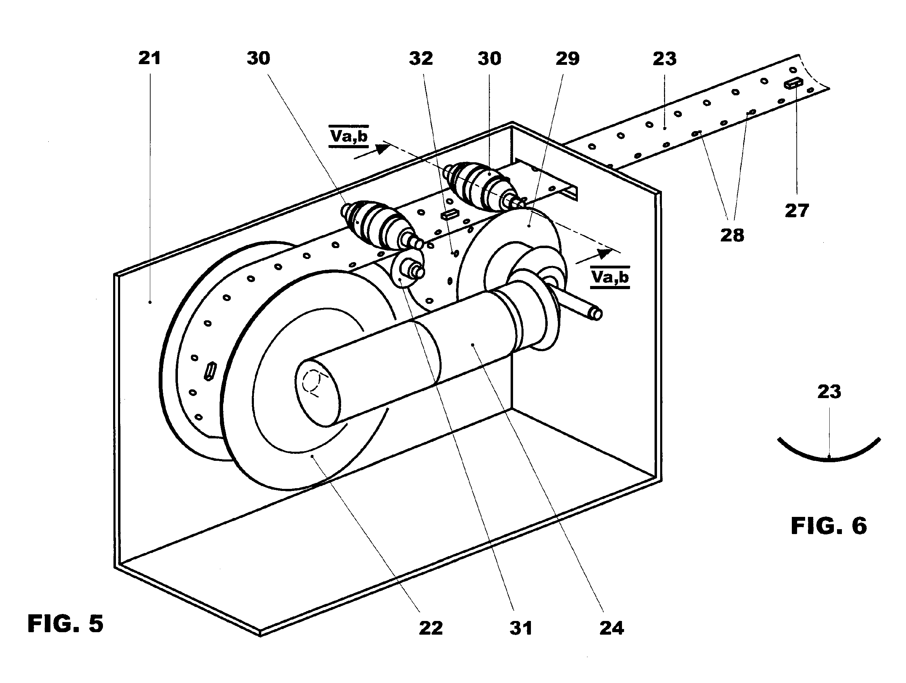

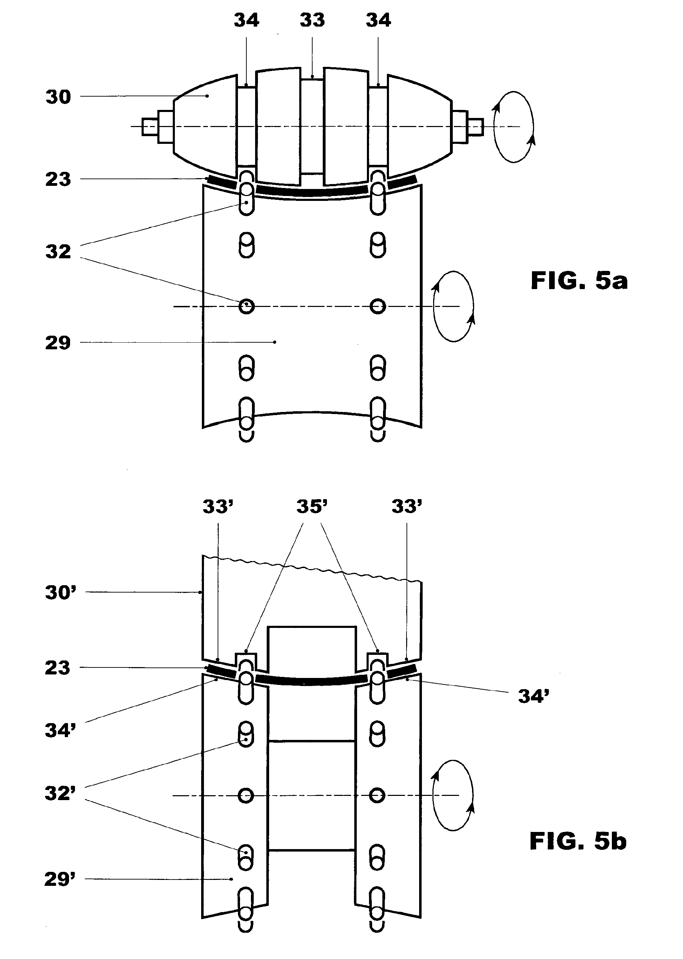

Figur 4 stellt die erfindungsgemässe Inspektionsvorrichtung als Ganzes dar, Figur 5 eine Ansicht einer Vorrichtung für das Auf- und Abrollen sowie der Führung des Trägers. Sie umfasst ein Gehäuse 21 für eine Lagerungsrolle 22 zur Lagerung eines Trägers 23 sowie verschiedene Elemente zum Auf- und Abrollen bzw. Ausfahren des Trägers aus dem Gehäuse 21. Am Ende des Trägers ist eine Sensorplattform 26 mit Sensoren für die Inspektion der Oberflächen, für eine Niederinduktions-Eisenmessung, eine Prüfung der Nutverkeilung und anderes angeordnet. Der Träger wird mittels eines Antriebs 24, der die Lagerungsrolle 22 sowie eine Transportwalze 29 antreibt, von der Lagerungsrolle 22 abgerollt. Der Antrieb 24 verfügt beispielsweise über eine Rückzugsfeder.

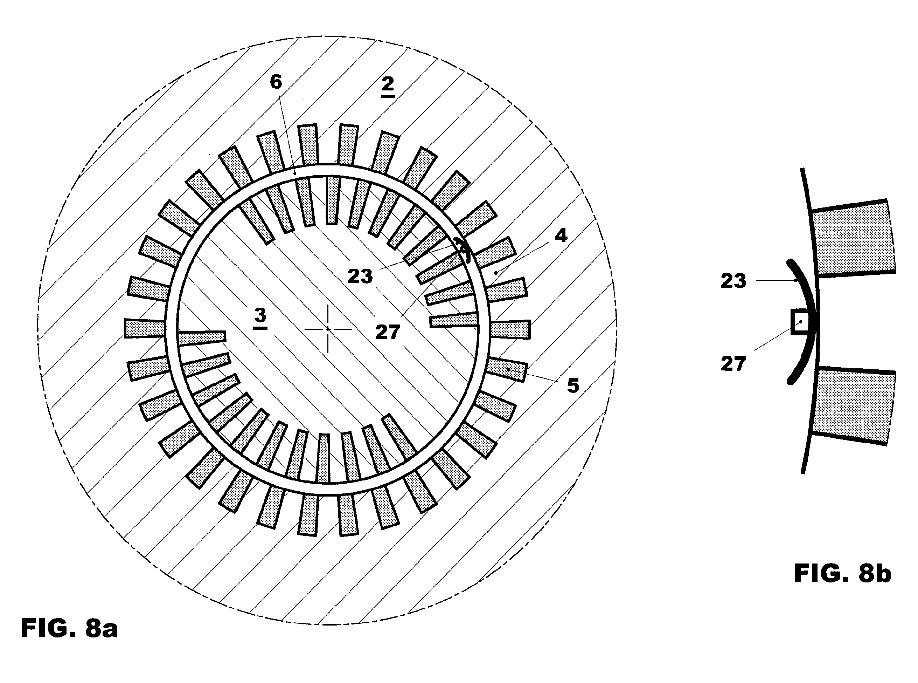

Die Transportwalze 29 weist über ihren Umfang zwei Reihen von regelmässig beabstandeten Tansportnocken 32 auf, die in Transportöffnungen 28 im Träger 23 eingreifen. Die Transportöffnungen sind hierzu ebenfalls in zwei parallel laufenden Längsreihen am Träger angeordnet, wobei Beabstandung, Form und Dimension jenen der Transportnocken angepasst sind und damit einen einwandfreien und rutschfreien Transport des Trägers gewährleistet. Im Gehäuse 21 befindet sich eine Öffnung 25, durch die der Träger aus dem Gehäuse 21 gefahren wird.
Am Träger 23 sind zudem entlang seiner Länge eine Mehrzahl von Magneten 27 befestigt, die über die Länge des Trägers verteilt sind. Diese ermöglichen eine Positionierung des Trägers und der Sensorplattform entlang den ferromagnetischen Oberflächen, ohne dass sich der Träger aufgrund der Schwerkraft von diesen ablöst. Die Magnete sind an der konkaven Oberfläche des Trägers befestigt, wobei diese konkave Oberfläche der ferromagnetischen Oberfläche abgewandt ist. Dies ermöglicht, dass der Träger entlang der ferromagnetischen Oberfläche gleitend bewegt werden kann, jedoch in Kontakt mit ihr bleibt und seine Position relativ zur ferromagnetischen Oberfläche aufrechterhält, siehe hierzu auch Figuren 8a und b.
Die Magneten 27 sind so klein wie möglich, insbesondere mit einer möglichst kleinen Bauhöhe, ausgebildet, dies um eine Lagerung des Trägers im aufgerollten Zustand in möglichst kleinem Raum zu ermöglichen. Die Magneten können entweder auf der Trägeroberfläche direkt mittels einem geeigneten Klebstoff befestigt sein. Als Alternative können die Magnete in Vertiefungen im Träger angeordnet und mittels Klebstoff befestigt sein. Um die Befestigung weiter zu stärken, kann ein in der Form leicht anpassbares Gewebe über die Magnete gelegt sein und mit Klebstoff gesichert sein.

Der Träger besteht vorzugsweise aus einem biegeelastischen Metall, wie zum Beispiel Stahl, das sich zum Aufrollen und Ausrollen eignet. Vorzugsweise und insbesondere um die Steifigkeit im ausgerollten Zustand zu erhöhen, steht der Träger im aufgerollten Zustand unter einer Einrollspannung und unter einer Querbiegespannung, wobei die Querbiegespannung grösser ist als die Einrollspannung. Dies trägt dazu bei, dass im ausgerollten Zustand der Träger einen gewölbten Querschnitt aufweist und dadurch in diesem Zustand eine Steifigkeit aufweist.
Um die Richtung des ausfahrenden Trägers 23 festzulegen, weist die Vorrichtung ein Paar von Führungswalzen 30, 31 auf, über die der Träger 23 geführt wird. Das Paar von Führungswalzen besteht jeweils aus einer Walze 30 mit konvexer und einer Walze 31 mit konkaver Querschnittsform von gleicher Krümmung, wobei diese zueinander, wie in Figur 5a) gezeigt, so angeordnet sind, dass die Wölbung der konvexen Walze in jene der konkaven Walze hineinragt und der Träger 23 zwischen den beiden hindurchführt. Die Führungswalzen 30 und 31 dienen dabei der Richtungsgebung des Trägers 23, wobei dieser die Wölbung, wie in Figur 6 gezeigt, beibehält. Die konvexen und konkaven Flächen der Walzen 30 und 31 stehen dabei so zueinander, dass der Träger 23 seine Längsrichtung, in die er ausgefahren wird, beibehält und nicht gebogen oder geknickt wird. Die konvexen Walzen 30 weisen etwa in deren Mitte und über ihren Umfang eine Nut 33 auf, durch welche die Magneten 27 passieren können. Weitere zwei Nuten 34 sind an der konvexen Walze 30 über ihren Umfang und jeweils auf der Höhe der Tansportnocken 32 und Transportöffnungen 25 angeordnet. Diese erlauben ein einwandfreies Passieren der Transportnocken 32.

In einer Variante der Erfindung ist die Führung des Trägers auch durch Elemente gemäss Figur 5b) realisierbar. Dort besteht ein Paar von Führungselementen aus einem fix befestigten Element 30' und einem um eine Achse rotierbare Walze 29'. Der Träger 23 wird zwischen den beiden Elementen hindurchgeführt, wobei die Walzen die Ausfahrrichtung des Trägers bestimmen. Beide Elemente weisen Flächen, die entweder gemäss der Wölbung des Trägers gekrümmt sind oder eine Tangente an die gewölbte Fläche des Trägers bilden. Wiederum weist das Element 30' in seinen Flächen 33' jeweils eine Nut 35' auf, welche die Nocken 32' passieren lassen.

Am Ende des Trägers 23 ist eine Sensorplattform 26 befestigt, auf der ein oder mehrere Sensoren und Messvorrichtungen angeordnet werden können, wie zum Beispiel eine Kamera, Wirbelstromsensor, Sensor zur Niederinduktions-Eisenmessung und weiteres. Zudem kann dort auch eine Elektronik angeordnet sein, beispielsweise zur Verstärkung, Digitalisierung und Komprimierung von Mess- und Bildsignalen.

Messsignale von den Sensoren werden mittels einer Elektronik auf der Sensorplattform zunächst verstärkt, digitalisiert, nach Bedarf komprimiert und schliesslich gemäss einem Übertragungsprotokoll übermittelt. Dies gewährleistet die notwendige Genauigkeit der Übertragung der typischerweise kleinen Signale.

Hierzu sind (nicht dargestellte) Kabel entlang dem Träger 23 befestigt. Diese werden bei der Lagerung des Trägers mit dem Träger auf die Lagerrolle 22 aufgerollt. Um die Übermittlung der Signale vom Ende des Trägers auf der sich drehenden Lagerungsrolle 22 an eine Signalverarbeitungsvorrichtung zu ermöglichen, weist die Vorrichtung an der Lagerrolle einen Schleifring auf.
Die Position der Sensorplattform im Spalt kann aufgrund von Impulssignalen des Antriebs 24 für die Lagerrolle 22 und Transportwalze 29 bestimmt werden, wobei deren Positionsgenauigkeit davon abhängt, dass der Träger während des Ausund Einfahrens nicht rutscht, d.h. von der Genauigkeit der Transportnocken und Transportöffnungen abhängt.

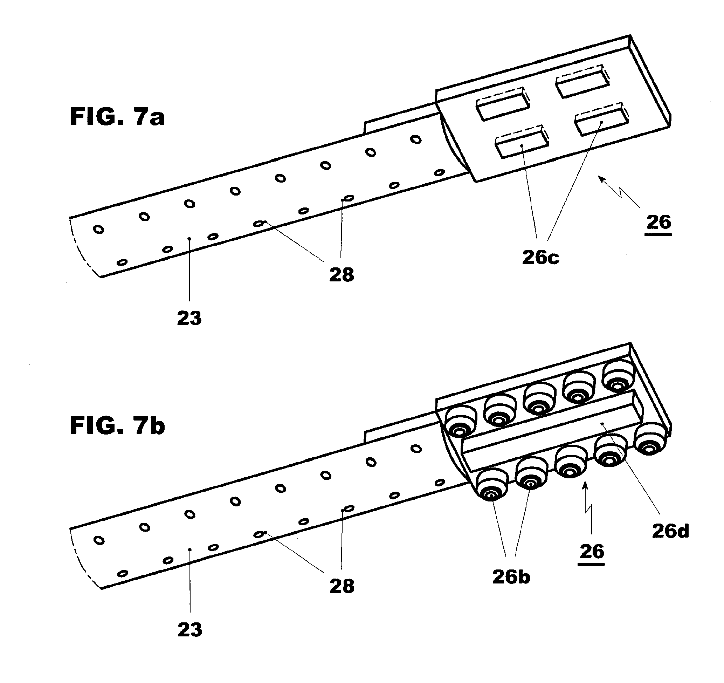

Figur 7a zeigt die Sensorplattform 26 aus der Sicht wie mit Pfeil VIIa in Figur 4 angedeutet und insbesondere die Seite der Sensorplattform, die in Kontakt mit einer ferromagnetischen Oberfläche kommt. In dieser ersten Variante ist die Sensorplattform 26 mit einer Anzahl von Magneten 26c bestückt, die im Material der Sensorplattform 26, eingebettet sind, wobei sie vom Plattformmaterial überdeckt sind. Dabei sind Magnetstärke und Beabstandung der Magnete von der Plattformoberfläche so gewählt, dass wiederum gewährleistet ist, dass die Plattform stets mit der ferromagnetischen Oberfläche in Kontakt bleibt. Indem die Magnete nicht von der Oberfläche der Plattform vorstehen, ist ein Gleiten entlang der ferromagnetischen Oberflächen ermöglicht. Alternativ können die Magneten 26c auch nur so weit im Plattformmaterial eingebettet sein, dass ihre Oberfläche in der gleichen Ebene liegt wie der Sensorplattform.

In Figur 7b zeigt in gleicher Ansicht wie in Figur 7a eine zweite Variante der Sensorplattform 26. Hier weist die Sensorplattform 26 ein oder mehrere Magneten 26d und eine Mehrzahl von Rollelementen 26b auf, welche die Bewegung entlang der ferromagnetische Oberfläche gewährleisten. Die Magnete 26d sind dabei nicht in direktem Kontakt mit der ferromagnetischen Oberfläche, garantieren jedoch aufgrund ihrer Stärke und Beabstandung von der ferromagnetischen Oberfläche, dass die Sensorplattform 26 in allen Positionen ihres Einsatzes, zum Beispiel in einem Generator, mit der ferromagnetischen Oberfläche in Kontakt bleibt.

Figuren 8a und b zeigen die Positionierung des Trägers 23 mit Sensorplattform 26 in einem Spalt 6 zwischen Stator 2 und Rotor 3 eines Generators. Es ist der gekrümmte Träger 23 im Querschnitt gezeigt mit einem Magneten 27 in Kontakt mit einer ferromagnetischen Oberfläche 4 des Stators.

### Bezugszeichenliste

- 1: Generator
- 2: Stator
- 3: Rotor
- 4: ferromagnetische Elemente
- 5: nicht-ferromagnetische Elemente
- 6: Luftspalt
- 7: Generator- /Rotor-Achse
- 8: Statorstab
- 9: Rotorkappe
- 10: Ventilator
- 20: Inspektionsvorrichtung
- 21: Gehäuse
- 22: Rolle zur Lagerung des Trägers
- 23: Träger
- 24: Antrieb
- 25: Öffnung
- 26: Sensorplattform
- 26a: Sensoren
- 26b: Rollelement
- 26c: Magnet
- 27: Magnet
- 28: Transportöffnungen
- 29: Führungs- und Transportwalze
- 30: Führungswalze (konvex)
- 31: Führungswalze (konkav)
- 32: Transport-Nocken
- 33: Nut in konvexer Walze
- 34: Nuten in konvexer Walze
- 33': schräg verlaufende Flächen in Element 30'
- 34': schräg verlaufende Flächen in Element 30'
- 35': Nuten in Element 30'
- d: Spaltbreite zwischen Rotorkappe 9 und Statorstab 8

## Patentansprüche

1. Eine Vorrichtung zur Inspektion eines Spaltes (6) zwischen zwei Oberflächen (4), wovon mindestens eine Oberfläche ferromagnetisch ist, weist eine Sensorplattform (26) mit einem oder mehreren Sensoren (26a) auf, die an einem länglich ausgebildeten, ausfahrbaren Träger (23) befestigt ist, wobei der Träger (23) durch eine Zugangsöffnung in den Spalt (6) ein- und herausführbar ist und mittels eines Antriebs (24) über die Länge des Spaltes (6) führbar und ausserhalb des Spaltes (6) aufrollbar ist und wobei der Träger (23) in einem zu seiner Längserstreckung senkrechten Querschnitt eine Krümmung aufweist
**dadurch gekennzeichnet, dass**
auf dem Träger (23) eine Mehrzahl von Magneten (27) angeordnet sind, die über die Länge des Trägers (23) verteilt sind und den Träger (23) in Kontakt mit einer ferromagnetischen Oberfläche (4) des Spaltes (6) bringen, wobei die Magnete (27) an einer Oberfläche des Trägers (23) befestigt sind, die von der ferromagnetischen Oberfläche (4) abgewandt ist.

2. Vorrichtung zur Inspektion eines Spaltes (6) nach Anspruch 1
**dadurch gekennzeichnet, dass**
die Sensorplattform (26) ein oder mehrere Magneten (26c, 26d) sowie eine oder mehrere Rollelemente (26b) oder Gleitelemente aufweist., wobei die Bauhöhe der ein oder mehreren Rollelemente (26b) oder Gleitelemente grösser als die der Magneten (26c, 26d) ist.

3. Vorrichtung zur Inspektion eines Spaltes (6) nach Anspruch 2
**dadurch gekennzeichnet, dass**
die Magneten (26c) der Sensorplattform (26) in der Sensorplattform (26) eingebettet sind und von einem gleitfähigen Material überdeckt sind oder deren Oberfläche in der Ebene der Sensorplattform (26) liegt.

4. Vorrichtung zur Inspektion eines Spaltes (6) nach einem der Ansprüche 1 bis 3
**dadurch gekennzeichnet, dass**
die Vorrichtung eine Träger- oder Lagerungsrolle (22) mit einer flachen Rollfläche aufweist, auf die der Träger mit einem flachen Querschnitt aufrollbar ist und von der er wieder abgerollt werden kann, und die Vorrichtung zusätzlich ein oder mehrere Paare von Führungselementen (29-31, 29', 30') aufweist, wobei jedes Paar von Führungselementen (29-31, 29', 30') aus einem Element (30) mit einem konvexen Flächen und einem Element (31) mit konkaven Flächen gleicher Krümmung besteht und das konvexe Element (30) bezüglich dem konkaven Element (31) so angeordnet ist, dass das konvex gekrümmte Teil des konvexen Elements (30) in das konkav gekrümmte Teil des konkaven Elements (31) hineinragt und der Träger (23) zwischen den beiden Führungselementen (29-30, 29', 30') hindurchführbar ist.

5. Vorrichtung zur Inspektion eines Spaltes (6) nach Anspruch 1
**dadurch gekennzeichnet, dass**
der Träger (23) entlang seiner Längsseiten eine Mehrzahl von regelmässig voneinander beabstandeten Öffnungen (28) und die Vorrichtung eine Transportwalze (29) mit einer Mehrzahl von Nocken (32) aufweist, die gemäss den Öffnungen (28) am Träger (23) dimensioniert und beabstandet sind.

6. Vorrichtung zur Inspektion eines Spaltes (6) nach Anspruch 1
**dadurch gekennzeichnet, dass**
entlang dem Träger (23) Kabel angeordnet sind zur Übermittlung von Messsignalen von dem einen oder den mehreren Sensoren (26a) auf der Sensorplattform (26) an das Ende des Trägers (23).

7. Vorrichtung zur Inspektion eines Spaltes (6) nach Anspruch 1
**dadurch gekennzeichnet, dass**
die Sensorplattform (26) eine Elektronik zur Digitalisierung der Messsignale und Übermittlung der Messsignale gemäss einem Übertragungsprotokoll aufweist.

8. Vorrichtung zur Inspektion eines Spaltes (6) nach Anspruch 6
**dadurch gekennzeichnet, dass**
die Vorrichtung eine Lagerungsrolle (22) zum Aufrollen des Trägers (23) aufweist und an dieser Lagerungsrolle (22) ein Schleifring angeordnet ist zur Übermittlung der Messsignale vom Ende des Trägers (23) an eine Signalverarbeitungs-Vorrichtung.

9. Vorrichtung zur Inspektion eines Spaltes (6) nach Anspruch 1
**dadurch gekennzeichnet, dass**
der Träger (23) aus einem oder mehreren länglichen, streifenförmigen Elementen aus einem biegeelastischen Metall besteht, der im ausgerollten Zustand im Querschnitt zu seiner Längserstreckung eine Krümmung mit einer konvexen und konkaven Seite aufweist.

10. Vorrichtung zur Inspektion eines Spaltes (6) nach Anspruch 9
**dadurch gekennzeichnet, dass**
der Träger (23) im ausgerollten Zustand unter einer Einrollspannung und unter einer Querbiegespannung steht, wobei die Querbiegespannung grösser ist als die Einrollspannung ist.

11. Vorrichtung zur Inspektion eines Spaltes (6) nach Anspruch 1
**dadurch gekennzeichnet, dass**
auf der konvexen Seite des Trägers (23) ein Streifen oder eine Beschichtung aus einem auf Metall gleitfähigen Kunststoff, Polytetrafluorethylen oder
Polyethylen angeordnet ist.

12. Vorrichtung zur Inspektion eines Spaltes (6) nach Anspruch 1
**dadurch gekennzeichnet, dass**
die Vorrichtung einen zusätzlichen Antrieb für ihre Bewegung über den Umfang eines Rotors (2) eines Generators (1) aufweist.

13. Vorrichtung zur Inspektion eines Spaltes (6) nach Anspruch 1
**dadurch gekennzeichnet, dass**
die Sensorplattform (26) einen oder mehrere Sensoren (26a) zur visuellen Inspektion oder Niederinduktions-Eisenmessungen aufweist.

14. Vorrichtung zur Inspektion eines Spaltes (6) nach Anspruch 8
**dadurch gekennzeichnet, dass**
die Lagerungsrolle (22) eine Rückzugsfeder aufweist.

15. Vorrichtung zur Inspektion eines Spaltes (6) nach Anspruch 1
**dadurch gekennzeichnet, dass**
die Magneten (27) jeweils in einer Vertiefung im Träger (23) angeordnet sind und mittels Klebstoff befestigt sind.

16. Vorrichtung zur Inspektion eines Spaltes (6) nach Anspruch 1
**dadurch gekennzeichnet, dass**
die Sensorplattform (26) ein oder mehrere Instrumente zum Greifen und Transportieren von Objekten im Spalt aufweist.

## Claims

1. Apparatus for inspection of a gap (6) between two surfaces (4), at least one surface of which is ferromagnetic, has a sensor platform (26) with one or more sensors (26a) which are attached to an elongated mount (23) which can be moved out, wherein the mount (23) can be moved into and out of the gap (6) through an access opening, can be moved over the length of the gap (6) and can be rolled up outside the gap (6) by means of a drive (24), and wherein, in a cross section at right angles to its longitudinal extent, the mount (23) has a curvature,
**characterized in that**
a plurality of magnets (27) are arranged on the mount (23), which magnets are distributed over the length of the mount (23) and bring the mount (23) into contact with a ferromagnetic surface (4) of the gap (6), wherein the magnets (27) are attached to a surface of the mount (23) facing away from the ferromagnetic surface (4).

2. Apparatus for inspection of a gap (6) according to Claim 1,
**characterized in that**
the sensor platform (26) has one or more magnets (26c, 26d) as well as one or more rolling elements (26b) or sliding elements, wherein the physical height of the one or more rolling elements (26b) or sliding elements is greater than that of the magnets (26c, 26d).

3. Apparatus for inspection of a gap (6) according to Claim 2,
**characterized in that**
the magnets (26c) of the sensor platform (26) are embedded in the sensor platform (26) and are covered by a material which can slide, or their surface lies on the plane of the sensor platform (26).

4. Apparatus for inspection of a gap (6) according to one of Claims 1 to 3,
**characterized in that**
the apparatus has a mounting or storage roller (22) with a flat rolling surface onto which the mount can be rolled with a flat cross section and from which it can be rolled off again, and the apparatus additionally has one or more pairs of guide elements (29-31, 29', 30'), wherein each pair of guide elements (29-31, 29', 30') comprises an element (30) with convex surfaces and an element (31) with concave surfaces with the same curvature, and the convex element (30) is arranged with respect to the concave element (31) such that the convex-curved part of the convex element (30) projects into the concave-curved part of the concave element (31), and the mount (23) can be moved through between the two guide elements (29 - 30, 29', 30').

5. Apparatus for inspection of a gap (6) according to Claim 1,
**characterized in that**
along its longitudinal sides, the mount (23) has a plurality of openings (28) which are separated from one another by a regular distance, and the apparatus has a transport roller (29) with a plurality of studs (32), which are designed and separated corresponding to the openings (28) on the mount (23).

6. Apparatus for inspection of a gap (6) according to Claim 1,
**characterized in that**
cables are arranged along the mount (23), in order to transmit measurement signals from the one or more sensors (26a) on the sensor platform (26) to the end of the mount (23).

7. Apparatus for inspection of a gap (6) according to Claim 1,
**characterized in that**
the sensor platform (26) has electronics in order to digitize the measurement signals and to transmit the measurement signals in accordance with a transmission protocol.

8. Apparatus for inspection of a gap (6) according to Claim 6,
**characterized in that**
the apparatus has a storage roller (22) for the mount (23) to roll on, and a slipring is arranged on this storage roller (22) in order to transmit the measurement signals from the end of the mount (23) to a signal processing apparatus.

9. Apparatus for inspection of a gap (6) according to Claim 1,
**characterized in that**
the mount (23) comprises one or more elongated elements which are in the form of strips and are composed of a flexibly elastic metal which, in the rolled-out state, has a curvature with a convex side and a concave side, in cross section, with respect to its longitudinal extent.

10. Apparatus for inspection of a gap (6) according to Claim 9,
**characterized in that**
in the rolled-out state, the mount (23) is subject to a rolling-in stress and is subject to a lateral bending stress, wherein the lateral bending stress is greater than the rolling-in stress.

11. Apparatus for inspection of a gap (6) according to Claim 1,
**characterized in that**,
on the convex side of the mount (23), there is arranged a strip or a coating composed of a plastic, polytetrafluorethylene or polyethylene, which can slide on metal.

12. Apparatus for inspection of a gap (6) according to Claim 1,
**characterized in that**
the apparatus has an additional drive for its movement over the circumference of a rotor (2) of a generator (1).

13. Apparatus for inspection of a gap (6) according to Claim 1,
**characterized in that**
the sensor platform (26) has one or more sensors (26a) for visual inspection or low-induction iron measurements.

14. Apparatus for inspection of a gap (6) according to Claim 8,
**characterized in that**
the storage roller (22) has a return spring.

15. Apparatus for inspection of a gap (6) according to Claim 1,
**characterized in that**
the magnets (27) are each arranged in a depression in the mount (23) and are attached by means of adhesive.

16. Apparatus for inspection of a gap (6) according to Claim 1,
**characterized in that**
the sensor platform (26) has one or more instruments in order to grip and transport objects in the gap.

## Revendications

1. Dispositif d'inspection de l'interstice (6) entre deux surfaces (4), au moins l'une de ces surfaces étant ferromagnétique,
le dispositif présentant une plateforme (26) de capteurs dotée d'un ou de plusieurs capteurs (26a) et fixée sur un support déployable (23) de configuration allongée,
le support (23) pouvant être inséré et extrait dans l'interstice (6) par une ouverture d'accès, pouvant être guidé sur la longueur de l'interstice (6) au moyen d'un entraînement (24) et pouvant rouler à l'extérieur de l'interstice (6),
le support (23) présentant une courbure dans une section transversale perpendiculaire à son extension longitudinale,
**caractérisé en ce que**
plusieurs aimants (27) répartis sur la longueur du support (23) et amenant le support (23) en contact avec une surface ferromagnétique (4) de l'interstice (6) sont disposés sur le support (23) et
**en ce que** les aimants (27) sont fixés sur une surface du support (23) non tournée vers la surface ferromagnétique (4).

2. Dispositif d'inspection d'un interstice (6) selon la revendication 1, **caractérisé en ce que** la plateforme (26) de capteurs présente un ou plusieurs aimants (26c, 26d) ainsi qu'un ou plusieurs éléments de roulement (26b) ou éléments coulissants, la hauteur du ou des éléments de roulement (26b) ou éléments coulissants étant supérieure à celle des aimants (26c, 26d).

3. Dispositif d'inspection d'un interstice (6) selon la revendication 2, **caractérisé en ce que** les aimants (26c) de la plateforme (26) de capteurs sont incorporés dans la plateforme (26) de capteurs et sont recouverts par un matériau lubrifiant, ou **en ce que** leur surface est située dans le plan de la plateforme (26) de capteurs.

4. Dispositif d'inspection d'un interstice (6) selon l'une des revendications 1 à 3, **caractérisé en ce que** le dispositif présente un rouleau de support ou de montage (22) doté d'une surface plane de roulement sur laquelle le support peut rouler par une section transversale plane et de laquelle il peut être déroulé, le dispositif présentant de plus une ou plusieurs paires d'éléments de guidage (29-31, 29', 30'), chaque paire d'éléments de guidage (29-31, 29', 30') étant constituée d'un élément (30) présentant une surface convexe et d'un élément (31) présentant une surface concave de même courbure, l'élément convexe (30) étant disposé par rapport à l'élément concave (31) de telle sorte que la partie de courbure convexe de l'élément convexe (30) pénètre dans la partie de courbure concave de l'élément concave (31) et que le support (23) puisse être amené entre les deux éléments de guidage (29-30, 29', 30').

5. Dispositif d'inspection d'un interstice (6) selon la revendication 1, **caractérisé en ce que** le support (23) présente le long de ses côtés longitudinaux plusieurs ouvertures (28) écartées régulièrement les unes des autres, le dispositif présentant un cylindre de transport (29) qui présente plusieurs cames (32) qui sont dimensionnées et écartées les unes des autres en correspondance aux ouvertures (28) ménagées sur le support (23).

6. Dispositif d'inspection d'un interstice (6) selon la revendication 1, **caractérisé en ce que** des câbles sont disposés le long du support (23) pour transmettre des signaux de mesure à l'extrémité du support (23) depuis le ou les différents capteurs (26a) prévus sur le plateforme (26) de capteurs.

7. Dispositif d'inspection d'un interstice (6) selon la revendication 1, **caractérisé en ce que** la plateforme (26) de capteurs présente une électronique de numérisation des signaux de mesure et de transmission des signaux de mesure selon un protocole de transfert.

8. Dispositif d'inspection d'un interstice (6) selon la revendication 6, **caractérisé en ce que** le dispositif présente un rouleau de montage (22) qui permet de faire rouler le support (23), une bague coulissante étant disposée sur ce rouleau de montage (22) pour transmettre les signaux de mesure de l'extrémité du support (23) à un dispositif de traitement de signaux.

9. Dispositif d'inspection d'un interstice (6) selon la revendication 1, **caractérisé en ce que** le support (23) est constitué d'un ou de plusieurs éléments allongés en forme de ruban en matériau élastique en flexion qui, à l'état déroulé, présente en section transversale par rapport à son extension longitudinale une courbure dotée d'un côté convexe et d'un côté concave.

10. Dispositif d'inspection d'un interstice (6) selon la revendication 9, **caractérisé en ce qu'**à l'état déroulé, le support (23) subit une contrainte d'enroulement et une contrainte de flexion transversale, la contrainte de flexion transversale étant supérieure à la contrainte d'enroulement.

11. Dispositif d'inspection d'un interstice (6) selon la revendication 1, **caractérisé en ce qu'**un ruban ou revêtement en une matière synthétique lubrifiée, en polytétrafluoroéthylène ou en polyéthylène, est disposé sur le métal du côté convexe du support (23).

12. Dispositif d'inspection d'un interstice (6) selon la revendication 1, **caractérisé en ce que** le dispositif présente en outre un entraînement qui permet son déplacement à la périphérie d'un rotor (2) d'un générateur (1).

13. Dispositif d'inspection d'un interstice (6) selon la revendication 1, **caractérisé en ce que** la plateforme (26) de capteurs présente un ou plusieurs capteurs (26a) d'inspection visuelle ou de mesure de fer à basse induction.

14. Dispositif d'inspection d'un interstice (6) selon la revendication 8, **caractérisé en ce que** le rouleau de montage (22) présente un ressort de rappel.

15. Dispositif d'inspection d'un interstice (6) selon la revendication 1, **caractérisé en ce que** les aimants (27) sont tous disposés dans un creux du support (23) et y sont fixés au moyen d'adhésif.

16. Dispositif d'inspection d'un interstice (6) selon la revendication 1, **caractérisé en ce que** la plateforme (26) de capteurs présente un ou plusieurs instruments qui saisissent et transportent des objets dans l'interstice.
